# EUROPEAN PATENT APPLICATION

(11) **EP 3 057 014 A1**
(43) Date of publication of application: **17.08.2016**
(21) Application number: 15200169.9
(22) Date of filing: 15.12.2015
(51) Int. Cl.: G06F 17/50, G06Q 10/04

(54) **EVACUATION SIMULATION DEVICE, EVACUATION SIMULATION METHOD, AND PROGRAM**

(30) Priority: 13.02.2015 JP 2015026688
(71) Applicant: Kozo Keikaku Engineering Inc., Tokyo 164-0012 (JP)
(72) Inventor: MORI, Toshikatsu, Nakano-ku, Tokyo 164-0012 (JP); HONDA, Kazuma, Nakano-ku, Tokyo 164-0012 (JP)
(74) Representative: White, Duncan Rohan

(57) **Abstract**

An evacuation simulation device (100) includes a first simulation execution unit (110) configured to derive, by a first simulation method, a plurality of optimal evacuation route candidates which has a possible shortest evacuation completion time, and a second simulation execution unit (120) configured to select, by a second simulation method, an optimal evacuation route which has the shortest evacuation completion time from the plurality of optimal evacuation route candidates.

## Description

### BACKGROUND OF THE INVENTION

### Field of the Invention

The present invention relates to an evacuation simulation device, an evacuation simulation method, and a program, and relates to a technique for generating an evacuation route according to, for example, a disaster situation.

### Description of Related Art

Various methods for predicting an evacuee's behavior when a disaster, such as a fire, occurs and formulating an appropriate evacuation plan are known. In a verification method for a conventional evacuation safety performance of a building, an engineer has been calculated an evacuation completion time when a disaster occurs according to a simplified expression based on a floor plan, a passage width, and the like in a design stage of the building, and evaluated the evacuation safety performance of the building. Furthermore, a verification method of an evacuation safety performance using a simulation by a computer instead of the simplified expression has been recently acknowledged, and there are a lot of past researches and package software.

For example, JP 4822812 B discloses a computer system which predicts, based on a phenomenon (that is, a disaster) which occurs at a route structure and on a route, the development of the phenomenon and behaviors of the people on the route.

Furthermore, JP 5372421 B discloses a computer system which follows an evacuation situation at a certain time during evacuation and specifies the bottleneck of the evacuation by modeling characteristics of an individual evacuee when a disaster occurs and successively reproducing the individual situation during the evacuation.

According to the evacuation simulation technique using these computer systems, when, for example, a building is newly designed, it is possible to design a floor layout having a high evacuation safety performance. More specifically, it is possible for a designer to create a floor layout which enables quicker and more appropriate evacuation by repeatedly formulating of an evacuation plan using the evacuation simulation technique and designing the floor layout to improve the evacuation plan. Furthermore, it is possible to evaluate the robustness of the evacuation plan to a change of a disaster scenario (a fire occurrence place, an evacuee attribution, and the like). Moreover, if an evacuation plan of an existing building is formulated by a similar method, the plan can be utilized for the education for staffs and people in the building.

### SUMMARY OF THE INVENTION

### Technical Problem

When an evacuation plan is formulated using a conventional evacuation simulation technique, a computer system normally executes a simulation based on a disaster scenario assumed in advance. However, an actual disaster situation does not necessarily correspond to the disaster scenario assumed in advance. For example, in the actual disaster, the route on which the evacuee can walk changes every moment, and an optimal evacuation route or an evacuation plan may also change every moment accordingly.

Therefore, when the evacuation simulation technique is applied to an actual disaster, it is desirable to update the evacuation plan according to the change of the disaster situation. In addition, it is desired to quickly and appropriately make a decision within a limited time. However, a conventional evacuation simulation technique disclosed in JP 4822812 B and JP 5372421 B has following problems. Firstly, since detailed characteristics of an individual evacuee are taken into consideration, the technique has tendency to increase the processing load and the calculation time. Secondly, a user requires to manually set a new disaster scenario and formulate a corrected evacuation route according to the actual disaster situation. In other words, the user requires to correct the evacuation route by trial and error. Due to these reasons, it has been difficult to apply the conventional evacuation simulation technique to the formulation of the evacuation plan when an actual disaster occurs.

The present invention has been made to solve the problems, and a purpose of the invention is to provide an evacuation simulation device, an evacuation simulation method, and a program which can quickly and appropriately formulate an evacuation plan according to an actual disaster situation.

The other problems and novel features will become apparent from the following description and the attached drawings.

### Solution to Problem

An evacuation simulation device according to an embodiment of the present invention includes a first simulation execution unit configured to derive, by a first simulation method, a plurality of optimal evacuation route candidates which has a possible shortest evacuation completion time, and a second simulation execution unit configured to select, by a second simulation method, an optimal evacuation route which has the shortest evacuation completion time from the plurality of optimal evacuation route candidates.

An evacuation simulation method according to an embodiment of the present invention includes a first simulation step of deriving, by a first simulation method, a plurality of optimal evacuation route candidates which has a possible shortest evacuation completion time, and a second simulation step of selecting, by a second simulation method, an optimal evacuation route which has the shortest evacuation completion time from the plurality of optimal evacuation route candidates.

A program according to an embodiment of the present invention stores a program causing a computer to execute the evacuation simulation method.

According to the present embodiments, first, the first simulation execution unit extracts the optimal evacuation route candidates by the easy and fast simulation method. Thus, it is possible to shorten the calculation time to derive the optimal evacuation route as much as possible. Furthermore, the second simulation execution unit executes the precise simulations of the optimal evacuation route candidates extracted by the first simulation execution unit and determines the optimal evacuation route. Thus, it is possible to derive a more appropriate evacuation route within the limited time.

### Advantageous Effects of Invention

According to the present invention, it is possible to provide an evacuation simulation device, an evacuation simulation method, and a computer-readable medium which can quickly and appropriately formulate an evacuation plan according to an actual disaster situation.

### BRIEF DESCRIPTION OF THE DRAWINGS

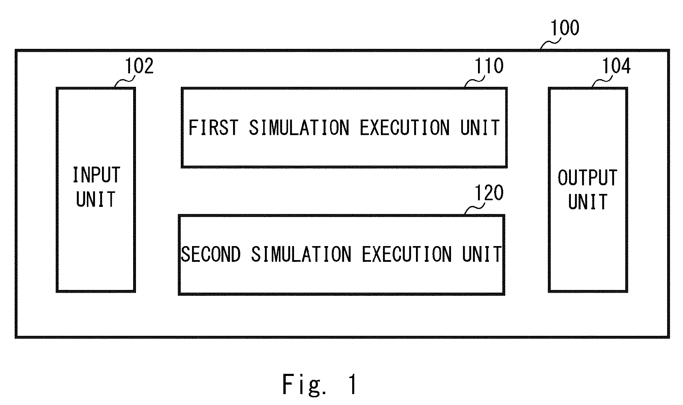

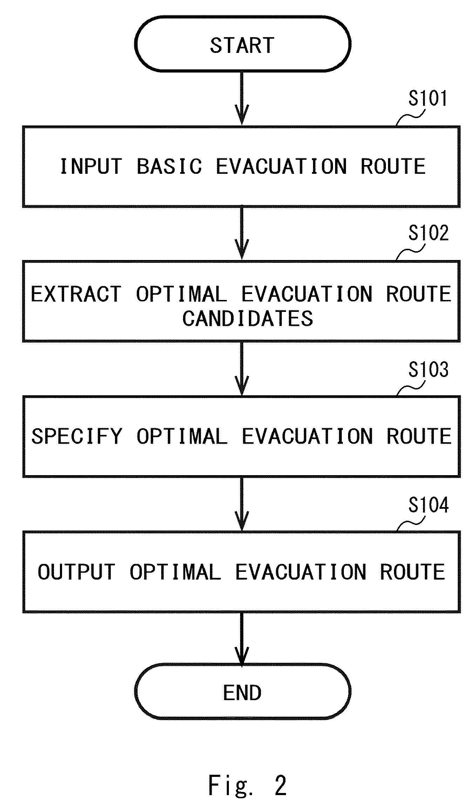

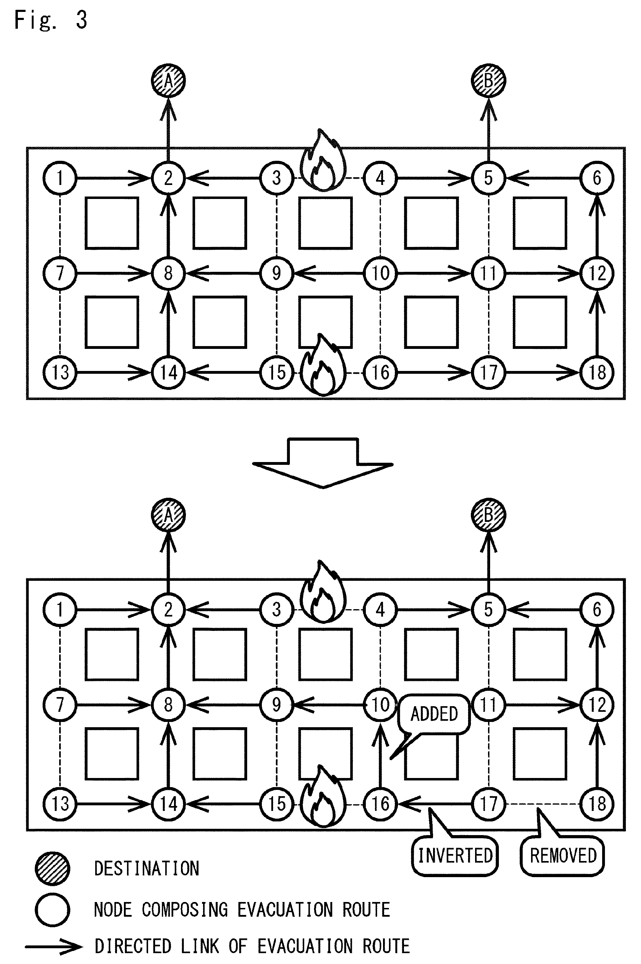

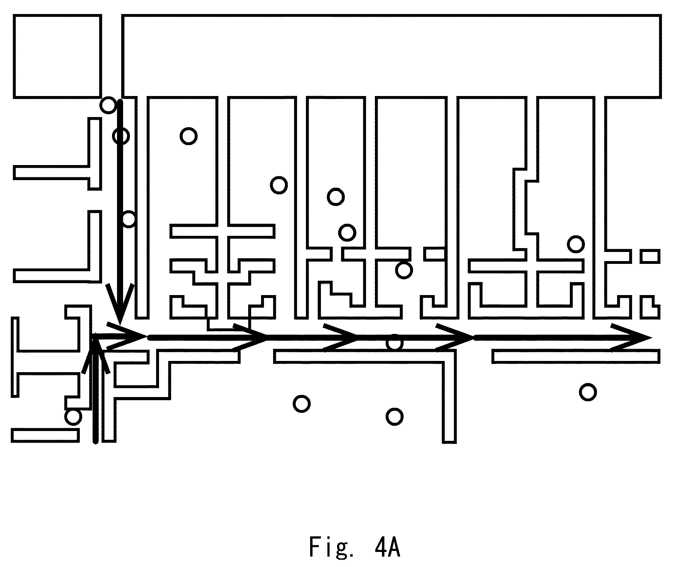

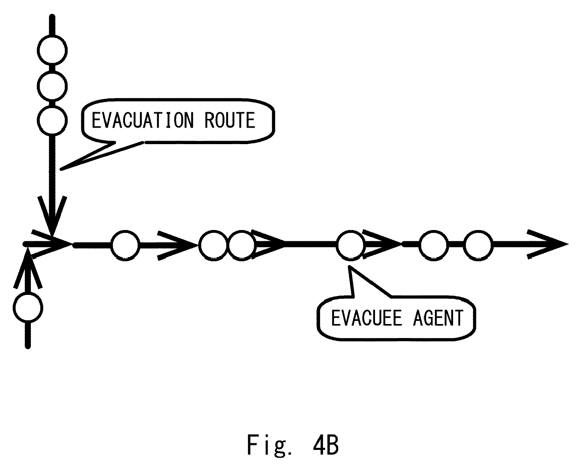

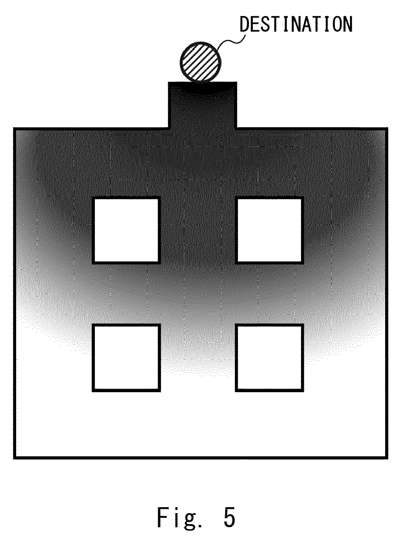

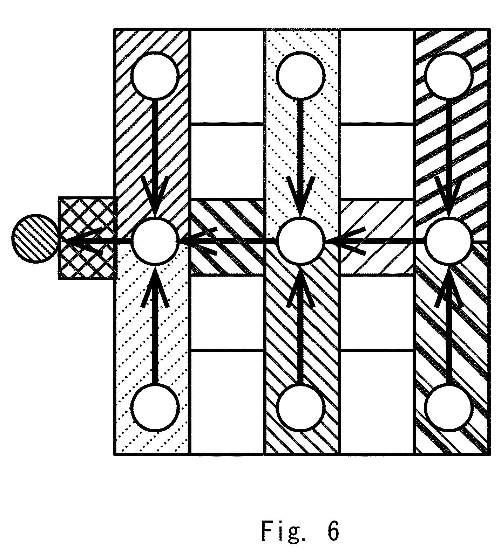

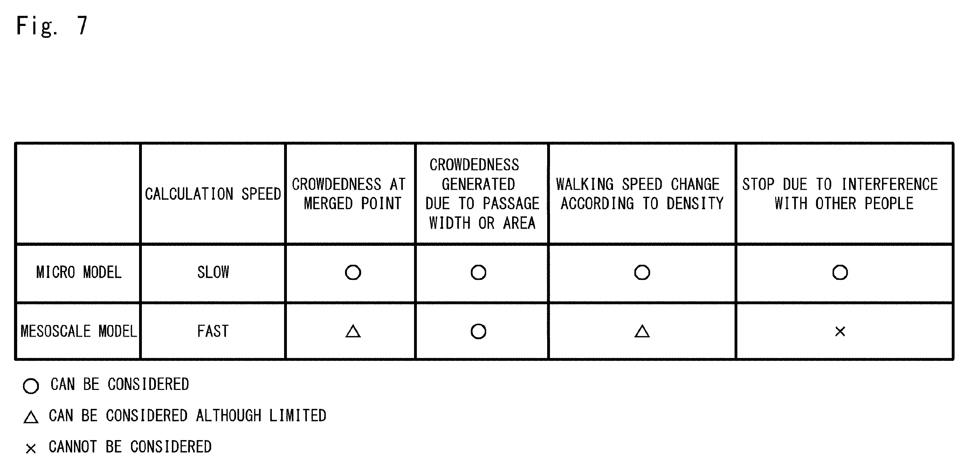

FIG. 1 is a diagram illustrating a configuration of a simulation device 100; FIG. 2 is a diagram illustrating operations of the evacuation simulation device 100; FIG. 3 is a diagram illustrating operations of a first simulation execution unit 110; FIG. 4A is a diagram illustrating operations of the first simulation execution unit 110 and a second simulation execution unit 120; FIG. 4B is a diagram illustrating operations of the first simulation execution unit 110 and the second simulation execution unit 120; FIG. 5 is a diagram illustrating operations of the second simulation execution unit 120; FIG. 6 is a diagram illustrating operations of the second simulation execution unit 120; and FIG. 7 is a table illustrating a comparison of the first simulation execution unit 110 with the second simulation execution unit 120.

### DESCRIPTION OF THE EXEMPLARY EMBODIMENTS

### <First Embodiment>

Hereinafter, concrete embodiments to which the present invention is applied will be described in detail with reference to the drawings.

First, with reference to the block diagram of FIG. 1, a configuration of an evacuation simulation device 100 according to a first embodiment of the present invention will be described.

The evacuation simulation device 100 includes an input unit 102, an output unit 104, a first simulation execution unit 110, and a second simulation execution unit 120.

The evacuation simulation device 100 is typically an information processing device, such as a personal computer (PC). The typical evacuation simulation device 100 includes a central processing unit (CPU), a storage device, and an input/output device. The CPU reads an application program stored in the storage device and executes predetermined processing. Whereby the CPU logically implements the input unit 102, the output unit 104, the first simulation execution unit 110, and the second simulation execution unit 120.

The input unit 102 acquires necessary information for an evacuation simulation, such as a space structure of a building, and the number, attribution and initial arrangement of evacuees. Furthermore, the input unit 102 acquires a basic evacuation route of the building. A part of or all of the information may be stored in the storage device, or may be externally input via an input device, such as a keyboard, or a communication interface. The input unit 102 outputs the acquired information to the first simulation execution unit 110 and the second simulation execution unit 120.

The first simulation execution unit 110 executes the evacuation simulation using a faster model than that in the second simulation execution unit 120, which will be described later. In the present embodiment, as an evacuation simulation method in the first simulation execution unit 110, an evacuation simulation by a mesoscale model, in which the evacuation route of the building is represented by a route network composed of a node and a one-dimensional link and an evacuee moves along with the one-dimensional link of the route network, is adopted (FIG. 3 and FIG. 4B).

The first simulation execution unit 110 outputs, as an evacuation simulation result, a plurality of evacuation routes which satisfies a predetermined standard. In other words, a plurality of candidates of an optimal evacuation route which shortens the entire evacuation time is output.

The second simulation execution unit 120 executes the evacuation simulation of each of the optimal evacuation route candidates output by the first simulation execution unit 110 using a more precise model than that in the first simulation execution unit 110. In the present embodiment, as an evacuation simulation method in the second simulation execution unit 120, an evacuation model simulation by a micro model, in which the building is represented by a two-dimensional space divided by an obstruction (wall) and the evacuee freely moves in the space, is adopted (FIG. 4A).

The second simulation execution unit 120 outputs, as a processing result, the route having the shortest evacuation time in total among the optimal evacuation route candidates, that is, the optimal evacuation route.

The output unit 104 outputs the optimal evacuation route output by the second simulation execution unit 120 so that a user can recognize the route by, for example, screen display.

Next, with reference to the flowchart of FIG. 2, the operations of the evacuation simulation device 100 according to the first embodiment will be described.

### S101: Inputting basic evacuation route

The input unit 102 acquires the basic evacuation route, and outputs the route to the first simulation execution unit 110. The basic evacuation route is used as an initial value when the first simulation execution unit 110 executes the evacuation simulation. The evacuation route assumed when the building is designed is typically used as the basic evacuation route.

The basic evacuation route is the data having a structure which can be used for the simulation method executed by the first simulation execution unit 110. For example, in the present embodiment, the evacuation simulation by the mesoscale model, in which the first simulation execution unit 110 represents the route of the building by the route network composed of the node and the one-dimensional link and the evacuee moves along with the one-dimensional link of the route network (FIG. 4B), is executed (FIG. 3). The basic evacuation route in this case is the data consisting of a combination of a plurality of nodes and the one-dimensional directed link connecting the nodes as illustrated in FIG. 3.

In addition, the input unit 102 acquires the necessary information for the evacuation simulation, such as a space structure of the building, and the number, attribution, and initial arrangement of the evacuees. In the present embodiment, the evacuation route of the building is defined as a network structure composed of the nodes and the one-dimensional link connecting the nodes as described above. The nodes include a node which is an evacuation destination (for example, destinations A and B in FIG. 3). Furthermore, a predetermined number of evacuees is assigned to a predetermined link as the initial value (initial arrangement).

The basic evacuation route and the above described other information may be stored in advance in a storage device, which is not illustrated, may be input by the user via an input device, such as a keyboard, or may be input from an external device via a communication interface or the like.

### S102: Extracting optimal evacuation route candidates

The first simulation execution unit 110 extracts a candidate group of the optimal evacuation route using the evacuation simulation by the mesoscale model and a local search. A basic framework of the local search will be described below.

Process 1: An initial solution X (the basic evacuation route) is input.

It is assumed that the basic evacuation route input in S101 is the initial solution X.

Process 2: The current solution X is randomly corrected, and a solution Y is generated.

The first simulation execution unit 110 randomly removes a link from the evacuation route indicated by the solution X, randomly adds another link, and generates the solution Y. For example, a link (17, 18) is removed, and a link (16, 10) is newly added in the solution X as illustrated in FIG. 3. A new evacuation route obtained in this manner is the solution Y.

Here, unless the solution Y is a tree structure, it is preferable that the first simulation execution unit 110 corrects the evacuation route to the tree structure by inverting the direction of a specified link included in the solution Y. For example, in the example of FIG. 3, the solution Y can be corrected to the tree structure where the destination A is the route node by inverting the link (16, 17).

The reason that the evacuation route is preferably the tree structure will be described. When an actual disaster occurs, it is generally desirable that the evacuation guide is a uniform direction. For example, it is practically difficult to achieve the evacuation guide so as to direct 50% of evacuees to the left evacuation route and the other 50% of the evacuees to the right evacuation route. In other words, the evacuation route leading an evacuation place which is a destination by following the evacuation route without encountering a forked road is desirable for the evacuees. Note that, it is allowable to merge another evacuation route into the middle of the evacuation route in an evacuation guide.

Note that, in an evacuation simulation method by a known mesoscale model, a method for representing the evacuation route considering the restrictions and algorithm for calculating the evacuation route based on the representation have not been proposed. In the conventional evacuation simulation method, the above described difficulty of the evacuation guide has not been focused, and a model based on the assumption that an individual evacuee evacuates according to the autonomous decision has been adopted. In other words, an evacuation time of the shortest route has been calculated based on a flow model described by an expression in advance, in which the evacuation route is represented by a network composed of a node and a link, and a predetermined branch rate is set to a branch point on the route.

Process 3: The solution X is replaced with the solution Y if an evacuation completion time of the solution X is shorter than that of the solution Y.

The first simulation execution unit 110 calculates the evacuation completion time of each of the solution X and the solution Y. More specifically, the time required for all evacuees to reach a destination is calculated based on a preset flow coefficient of each link (the number of evacuees who can pass through a link per unit time), a density-speed relational expression, and the number of evacuees at each node. Note that, the concrete expressions for the calculation is known, and the detailed description thereof is omitted.

Note that, it is desirable that the above described flow coefficient and density-speed relational expression are adjusted so as to match the evacuation simulation result by the mesoscale model with the evacuation simulation result by the micro model, which will be described later, as much as possible.

Thereafter, the first simulation execution unit 110 replaces the solution X with the solution Y if the evacuation completion time of the solution Y is shorter than that of the solution X.

Process 4: The processes 2 and 3 are repeated until a termination condition is satisfied.

The first simulation execution unit 110 repeatedly executes the processes 2 and 3 until the preset termination condition is satisfied. By repeating the trial, it is possible to find a more appropriate evacuation route.

The repeated calculation can be terminated when, for example, the number of repetitions reaches a preset value. Alternatively, the repeated calculation may be terminated when it is determined that the evacuation completion time converges by using a known convergence determination method.

Thereafter, the first simulation execution unit 110 stores the solution X as the evacuation route which has the shortest evacuation completion time (the optimal evacuation route candidate).

The first simulation execution unit 110 repeatedly executes the above described processing of the processes 1 to 4 a predetermined number of times. Thus, a plurality of optimal evacuation route candidates is obtained.

### S103: Specifying optimal evacuation route

The second simulation execution unit 120 executes the evacuation simulation by the micro model, in which the building is represented by the two-dimensional space divided by the obstruction (wall), and the evacuee freely moves in the space. Here, the second simulation execution unit 120 evaluates the optimal evacuation route candidates calculated in S102 with the evacuation simulation by the micro model and specifies the optimal evacuation route having the shortest evacuation time.

Incidentally, an evacuation simulation method using a known micro model is based on the assumption of the shortest distance evacuation from the present position to the destination, and it is difficult to execute the evacuation simulation specifying the evacuation route which does not have the shortest distance, such as a detour. In other words, in the known micro model, the shortest distance to the destination (a potential value) is set to the space to which the evacuee moves, and the evacuee moves from the present position in the direction decreasing the potential value as illustrated in FIG. 5. Therefore, it is difficult to intentionally form the evacuation route in which the evacuee moves along the link as considered in the above described mesoscale model.

On the other hand, in the present embodiment, the space inside the building is divided into areas corresponding to the links in the above described mesoscale model as illustrated in FIG. 6. Then, the potential value in each corresponding area is calculated so as to spread in the direction to the destination of the link corresponding to the area, and from the start point node to the terminal node of the link. Thus, in the case using the micro model, it is possible to move the evacuee in the direction along the shortest evacuation route candidate calculated by the first simulation execution unit 110. In other words, it is possible to perform, by the micro model, the evacuation simulation of the shortest evacuation route candidate calculated by the mesoscale model.

The second simulation execution unit 120 calculates the evacuation completion time of each of the optimal evacuation route candidates in the case where the evacuees evacuate with the evacuation route using the micro model. As the micro model, for example, a multi-agent method, or a cellular automaton method can be adopted. In the present embodiment, in the case where the evacuees evacuate in the direction having a small potential value while colliding with and avoiding each other, the time for all of the evacuees to reach the destination is calculated. Note that, since the concrete method for the calculation is known, the detailed description thereof is omitted in the description.

Here, the difference between the mesoscale model executed by the first simulation execution unit 110 and the micro model executed by the second simulation execution unit 120 is illustrated in FIG. 7. Although the calculation speed of the micro model is slower than that of the mesoscale model, the crowdedness at a merged point, the walking speed change according to the density, and a stop due to interference with other people are taken into consideration in the micro model, and it is possible to precisely simulate the evacuation completion time.

Finally, the second simulation execution unit 120 outputs, to the output unit 104, the evacuation route having the shortest evacuation completion time (the optimal evacuation route) as the above described calculation result. Typically, the second simulation execution unit 120 outputs, as the shortest evacuation route, the tree structure composed of the node and link, and corresponding to the shortest evacuation completion time calculated in the micro model.

### S104: Outputting optimal evacuation route

The output unit 104 shows the optimal evacuation route to the user. For example, the output unit 104 superimposes a link indicating the shortest evacuation route on the plan view of the building and displays the link on the display.

According to the present embodiment, first, the first simulation execution unit 110 extracts the optimal evacuation route candidates by the easy and fast simulation method. Thus, it is possible to shorten the calculation time to derive the optimal evacuation route as much as possible.

Furthermore, according to the present embodiment, the second simulation execution unit 120 executes the precise simulations of the optimal evacuation route candidates extracted by the first simulation execution unit 110 and determines the optimal evacuation route. Thus, it is possible to derive a more appropriate evacuation route within the limited time.

Moreover, in the present embodiment, the first simulation execution unit 110 generates a large number of routes in which a part of the basic evacuation route is changed, executes the evacuation simulations of the various evacuation routes, and extracts the optimal evacuation route candidates which shorten the evacuation completion time in total. Thus, the evacuation route verification which has been manually performed by trial and error is automated, and it is possible to quickly extract the optimal evacuation route candidates when an actual disaster occurs.

### <Second Embodiment>

An evacuation simulation device 100 according to a second embodiment has a characteristic in an evacuation route rearrangement strategy in processes 2 and 3 of S102. The other configurations and operations are similar to those of the first embodiment, unless particularly mentioned.

In S102 (the extraction processing of the optimal evacuation route candidates), and the process 2 (the processing to randomly correct the current solution X and generate the solution Y) of the first embodiment, since the link to be removed and to be corrected is randomly selected, the processing may be inefficient and take much time sometimes, and may not be appropriate when an actual disaster occurs. In order to solve the problem, a rearrangement strategy of two types of links is proposed in the second Embodiment.

### Strategy A: Eliminating a link pattern which may worsen the route

A first simulation execution unit 110 randomly removes a link from an evacuation route indicated by a solution X, randomly adds another link, and generates a solution Y in the process 2. Subsequently, an evacuation completion time of each of the solution X and the solution Y is calculated in the process 3.

Here, when the evacuation completion time of the solution Y is longer than that of the solution X, that is, when the evacuation route is worsened by adding or removing the link, the first simulation execution unit 110 holds, as a deteriorating link pattern, the added and removed link at this time. Then, in the subsequent trials, the link included in the deteriorating link pattern is not to be added or removed in the process 2.

Note that, thereafter, when the evacuation completion time of the solution Y is faster than that of the solution X, the first simulation execution unit 110 preferably clears the deteriorating link pattern. This is because that the deteriorating link pattern may be changed by replacing the solution.

### Strategy B: Switching a link selection strategy in the middle of repetition processing

During the repetition processing of the processes 1 to 4, the first simulation execution unit 110 allows to rearrange the link straddling the evacuation routes to the different destinations in the first half of the repetition processing. In other words, a rearrangement, in which for example, a link belonging to the tree structure where a destination B is a route node is changed so as to belong to the tree structure where a destination A is the route node, may be performed as illustrated in FIG. 3. Thus, it is possible to widely roughly search for the evacuation route which may shorten the evacuation time.

On the other hand, the first simulation execution unit 110 rearranges the links limited within the evacuation route to the same destination in the other half of the repetition processing. In other words, for example in FIG. 3, if a removed link (8, 9) is selected from the tree structure where the destination A is the route node, the rearrangement is performed so that an added link (3, 9) is set to the tree structure where the same destination A is the route node. Thus, it is possible to perform the search to improve the evacuation route corresponding to each destination.

According to the present embodiment, since the first simulation execution unit 110 eliminates the rearrangement pattern of the link which may worsen the evacuation completion time, it is possible to improve the efficiency in the extraction processing of the optimal evacuation route candidates.

Furthermore, according to the present embodiment, since the first simulation execution unit 110 switches the link selection strategy in the middle of the repetition processing, it is possible to widely search for the evacuation route which may shorten the evacuation time, and to improve the evacuation route corresponding to each destination.

Note that, the present invention is not limited to the above described embodiments, and can be appropriately changed without departing from the scope of the invention. For example, the number, attribution, and initial arrangement of evacuees can be input from a known system for grasping the number of people in building. The typical system for grasping the number of people in building can estimate the number of people on each floor in the building from an access control log using a security card, or the like. Furthermore, by recognizing a moving image using a surveillance camera or the like, it is possible to estimate the number of people on each floor in the building and the attribution data (walking speed and the like).

Furthermore, the optimal evacuation route output in the above described embodiments can be output to an existing evacuation guide system. In this case, information on the optimal evacuation route can be linked with an evacuation guide indicator (a digital signage or the like), a broadcasting, an operation system for an emergency elevator, and the like.

Moreover, the building which is the simulation target of the evacuation route in the above described embodiments may be, for example, a high-rise building, such as an office building or an apartment building, a commercial complex, a stadium, a large-sized hall, or a large-sized passenger ship.

Furthermore, in the above described embodiments, although the present invention has been described as it is mainly composed of hardware, the present invention is not limited to this, and may be implemented by causing a CPU to execute an arbitrary processing as a computer program. In this case, the computer program is stored in various types of non-transitory computer-readable mediums (non-transitory computer-readable mediums) and can be supplied to the computer. The non-transitory computer-readable medium includes various types of tangible storage mediums. The non-transitory computer-readable medium includes a magnetic storage medium (for example, a flexible disk, a magnetic tape, and a hard disk drive), a magneto-optical storage medium (for example, a magneto-optical disk), a CD-read only memory (ROM), CD-R, CD-R/W, a semiconductor memory (for example, a mask ROM, a programmable ROM (PROM), an erasable PROM (EPROM), a flash ROM, and a random access memory (RAM)). Furthermore, the program may be supplied to the computer by various types of transitory computer-readable mediums. The transitory computer-readable medium includes, for example, an electrical signal, an optical signal, and an electromagnetic wave. The transitory computer-readable medium can provide a computer with a program via a wired communication path, such as an electric wire and an optical fiber, or a wireless communication path.

### Reference Signs List

- 100: evacuation simulation device
- 102: input unit
- 104: output unit
- 110: first simulation execution unit
- 120: second simulation execution unit

## Claims

1. An evacuation simulation device comprising:
a first simulation execution unit (110) configured to derive, by a first simulation method, a plurality of optimal evacuation route candidates which has a possible shortest evacuation completion time; and
a second simulation execution unit (120) configured to select, by a second simulation method, an optimal evacuation route which has the shortest evacuation completion time from the plurality of optimal evacuation route candidates.

2. The evacuation simulation device according to claim 1, wherein a calculation time of the evacuation completion time by the first simulation execution unit (110) is shorter than a calculation time of the evacuation completion time by the second simulation execution unit (120).

3. The evacuation simulation device according to claim 1 or 2, wherein the first simulation execution unit (110) searches for the plurality of optimal evacuation route candidates by comparing the evacuation completion time of a first evacuation route including a plurality of nodes and links with that of a second evacuation route in which the link in the first evacuation route is randomly rearranged.

4. The evacuation simulation device according to claim 3, wherein when the evacuation completion time of the second evacuation route is longer than that of the first evacuation route, the first simulation execution unit (110) holds the rearranged link as a specified link and repeatedly executes the search after excluding the specified link from the rearrangement target.

5. The evacuation simulation device according to claim 3, wherein
plurality of the nodes and the links form a tree structure, and
the first simulation execution unit (110) executes the search by a first phase which allows the rearrangement straddling a plurality of the tree structures and a second phase which does not allow the rearrangement straddling the plurality of the tree structures.

6. The evacuation simulation device according to any one of claims 1 to 5, wherein the second simulation execution unit (120) selects the optimal evacuation route based on a simulation model, in which an autonomous evacuee moves in an area equivalent to one of the plurality of optimal evacuation route candidates.

7. An evacuation simulation method comprising:
a first simulation step of deriving, by a first simulation method, a plurality of optimal evacuation route candidates which has a possible shortest evacuation completion time; and
a second simulation step of selecting, by a second simulation method, an optimal evacuation route which has the shortest evacuation completion time from the plurality of optimal evacuation route candidates.

8. A program causing a computer to execute the method according to claim 7.
